# EUROPEAN PATENT SPECIFICATION

(11) **EP 0 589 123 B1**
(45) Date of publication and mention of the grant of the patent: **24.06.1998**
(21) Application number: 92830513.5
(22) Date of filing: 23.09.1992
(51) Int. Cl.: H03K 17/06

(54) **A driver circuit for an electronic switch**
Treiberschaltung für einen elektronischen Schalter
Circuit d'attaque pour un commutateur électronique

(43) Date of publication of application: 30.03.1994
(73) Proprietor: SGS-THOMSON MICROELECTRONICS s.r.l., 20041 Agrate Brianza (Milano) (IT)
(72) Inventor: Tomasini, Luciano, I-20052 Monza (MI) (IT); Castello, Rinaldo, I-20043 Arcore (MI) (IT); Confalonieri, Pierangelo, I-24040 Canonica d'Adda (BG) (IT)
(74) Representative: Botti, Mario

(56) References cited:
- EP-A- 335 217
- FR-A- 2 162 159

## Description

This invention relates to a driver circuit for an electronic switch, of the type comprising a logic gate receiving on a first input terminal a first clock signal having a predetermined frequency and a voltage doubler, connected between a second input terminal, receiving a second clock signal, and the switch.

The field of application of this invention is particularly, but not exclusively, related to that of field-effect transistor driving, and this description will make reference to that application for simplicity.

As it is well known, in electronic circuits integrated on semiconductors, the transistors may also be called upon to perform current flowing cut-off functions. In such applications, the transistors are viewed as switches adapted to be operated by clock signals at either periodical or fixed or variable frequencies.

Where such transistors are of the field-effect MOS type, in order to have the switch "make", the value of the gate/source voltage Vgs should exceed by a few hundred millivolts the threshold voltage Vth as boosted by the so-called body effect.

A known prior art solution is disclosed in the European patent application No. 0 335 217 which relates to an integrated circuit comprising a transistor and a Schottky diode included charge pump circuit. The charge pump circuit is provided to drive the gate terminal of an output transistor connected between a supply voltage reference and a load.

It often happens that, in order to make the most out of the available dynamic range, two paired MOS transistors are used. A typical example of this utilization pattern is the so-called switched capacitor filters.

Such transistor pairs generally comprise an N-channel MOS transistor connected to a P-channel transistor. These are both driven by a voltage signal which may vary between a maximum supply value Vdd and a zero value.

When the signal voltage is close to zero, only the N-channel transistor is in operation; conversely, when the signal voltage is close to the maximum value Vdd, the P-channel transistor only is in operation. And when the signal has a value of Vdd/2, both transistors are in operation.

On the other hand, if the signal is less than the threshold voltages of both transistors, taken together and inclusive of the body effect, it is likely that neither transistors can be turned on and, therefore, that no switch can be controlled to make. This would particularly occur across a range of voltage values lying centrally with respect to the maximum value Vdd.

To obviate any such drawbacks, one might consider of shifting the signal range of values more toward Vdd (in which case, P-type transistors would only be used) or toward zero (when N-type transistors would only be used).

Shifting the common mode value of a signal upwards or downwards from the supply value Vdd results in the dynamic range of the signal being reduced.

Such an approach would, therefore, affect the signal-to-noise ratio adversely since the dynamic range, which has been diminished already by the low supply value, would be further reduced by so doing.

Another prior art approach provides for the threshold voltages of the MOS transistors to be lowered such that a situation for potential appearance of the problem can be avoided, i.e. that the supply voltage is less than the combined thresholds plus the body effect.

However, not even the latter solution is always practicable because it clashes with the operational requirements of the transistors which, if arranged to have a threshold Vth below a certain value, can no longer perform as intended, especially where they are to operate under varying conditions of temperature and voltage.

The underlying technical problem of this invention is to provide a driver for an electronic switch, which has such structural and functional features as to overcome the above-mentioned drawbacks with which the prior art approaches are beset.

The solutive idea on which the invention stands is the recognition that it is not necessary to multiply the driving voltage of the cllock signals by high factors, it being sufficient to have it raised by a factor of two.

Based on this solutive idea, the technical problem is solved by a driver circuit of the kind outlined above and defined in the characterizing part of Claim 1.

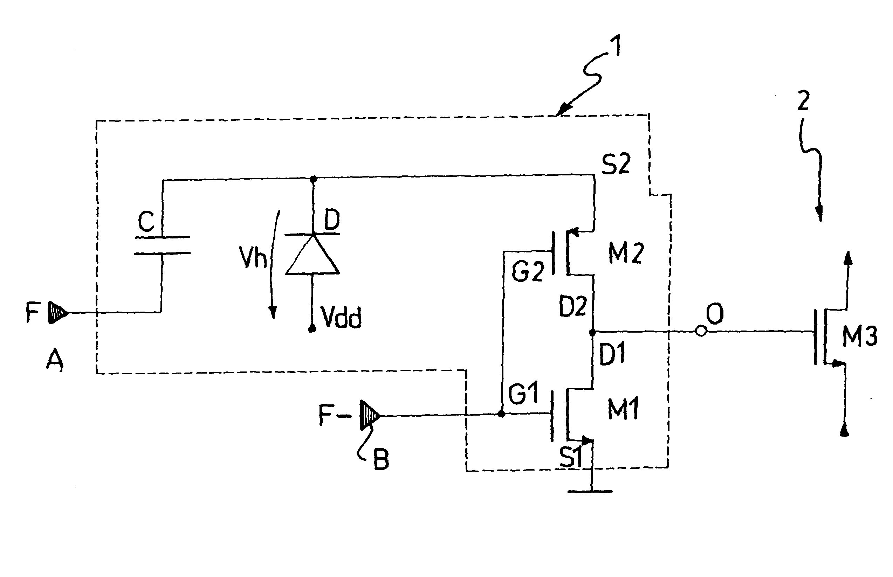

The features and advantages of a circuit according to the invention will become apparent from the following detailed description of an embodiment thereof, given by way of example and not of limitation in connection with an associated impedance synthesizing circuit illustrated in the accompanying drawing.

The single figure of the drawing shows diagramatically a driver circuit embodying this invention.

With reference to the drawing figure, generally and schematically shown at 1 is a driver circuit for an electronic switch 2. In particular, the circuit 1 is associated with said switch 2 to operate it according to a clock signal F having a predetermined frequency.

The switch 2 comprises an N-channel MOS transistor M3 whose gate is connected to the circuit output O, whilst its drain and source form the switch terminals.

This driver circuit 1 includes an output circuit portion implemented with a pair of field-effect transistors M1 and M2 connected to each other. Specifically, these transistors are of the MOS type and have their respective drain terminals D1, D2 in common.

Said drain terminals D1 and D2 also coincide with the output O of the circuit 1. The first, M1, of such transistors is an N-channel type and has its source terminal S1 connected to ground.

The second transistor, M2, is instead of the P-channel type and has its source terminal S2 connected to a first input pin A of the circuit 1 through a capacitor C.

Said source terminal S2 is also connected, via a diode D, to a constant voltage supply Vdd. The diode D is forward biased to the supply Vdd.

Further, the transistors M1 and M2 have their respective gate terminals G1, G2 connected together and to a second input pin B.

The input pins A and B are applied periodic clock voltage signals having respective phases F and F- which are generated within the voltage range of values 0-Vdd. The phases have comparatively small amplitudes due, in fact, to they varying between zero and the supply value Vdd.

Additionally, they are "non-overlapping", that is, they never take the value of Vdd simultaneously, which is specially important for proper performance of the circuit 1.

The operation of the inventive circuit will now be described with reference to an initial state wherein the phase F- at the second input B is high (Vdd), whereas the other phase, F, at the input A is low (0).

Under such starting conditions, the output O would surely be at zero volts because the first MOS transistor M1 is conducting, it having a gate-to-source voltage drop equal to the supply voltage Vdd. The other transistor M2 is shut down since it has the drain D2 and source S2 both at a lower voltage level than the gate G2.

In the meantime, the capacitor C has been charged, by a current flowing through the diode D, to a pre-charging voltage Vc equal to Vdd-Vh, where Vh is the voltage drop across the diode D.

Upon depletion of the charging transient of the capacitor C, the voltage drop Vh will become quite small, as small is also the current being flowed through the diode. Upon the phase F- attaining zero value, the first transistor M1 will be shut down, whereas the second transistor M2 is turned on to pre-charge the output O to a value of Vdd-Vh.

The other phase F rises after a short delay up to the value of Vdd, and the upper plate of the capacitor C is almost instantaneously applied a voltage being the sum Vc+Vdd. This voltage is nearly twice the supply voltage Vdd.

The diode D is reverse biased.

Basically, the circuit 1 behaves as a voltage doubler for the clock signal.

If we now denote by Ct the overall capacitance as seen from the output O, said overall capacitance also encompassing all the parasitic capacitors associated with the transistors and the diode D, we can find the value of the output voltage Vo as follows,$\text{Vo = Vc + C * Vdd/(C+Ct)}$

The second term of the sum is due to the capacitive division of the circuit 1.

The clock signal cycle is completed on the phase F returning to zero and the other phase F- returning to the value of Vdd. This will restore the circuit 1 to its starting condition with the output O at zero value.

Advantageously, the capacitance C can be quite small, since the first rise period of the output voltage Vo is provided directly by the voltage supply Vdd. The capacitor C would only be operative during the final portion of the transient.

The second, P-channel, MOS transistor can also have a smaller area than in prior art solutions because all of the possible gate-to-source voltage is made available to it.

The circuit of this invention does solve the technical problem and affords a number of advantages, of which a major one is that the output O will be at its maximum voltage value already from the first clock cycle.

To summarize, this circuit requires no start-up time in order to be brought to steady state operation.

## Claims

1. A driver circuit for an electronic switch (2), said driver circuit comprising a logic gate receiving on a first input terminal (B) a first clock signal (F-) having a predetermined frequency and a voltage doubler, connected between a second input terminal (A), receiving a second clock signal (F), and the switch (2), characterized in that said logic gate includes a pair of field-effect transistors (M1,M2) having respective gate terminals (G1,G2) in common to form said first input terminal (B) and respective drain terminals (D1,D2) in common to form the output (O) of the driver circuit to said switch (2) and in that said voltage doubler comprises:
- a capacitor (C) having one terminal connected to said second input terminal (A) and a second terminal connected to the source terminal of one (M2) of said transistors (M1, M2) to provide a pumped voltage to power said logic gate; and
- a diode (D) connecting the second terminal of said capacitor to a constant voltage supply (Vdd).

2. A circuit according to Claim 1, characterized in that said diode (D) is forward biased to said voltage supply (Vdd).

3. A circuit according to Claim 1, characterized in that said pair of transistors (M1, M2) comprises a first, N-channel, MOS transistor (M1) and a second, P-channel, MOS transistor (M2) having respective drain terminals (D1,D2) in common to form the drive output (O) of said circuit.

4. A circuit according to Claim 1, characterized in that said first clock signal (F-) and said second clock signal (F) are non-overlapping.

## Patentansprüche

1. Treiberschaltung für einen elektronischen Schalter (2), umfassend ein logisches Gatter, welches an einem ersten Eingangsanschluß (B) ein erstes Taktsignal (F-) mit einer vorbestimmten Frequenz empfängt, und einen Spannungsverdoppler, der zwischen einem zweiten Eingangsanschluß (A), der ein zweites Taktsignal (F) empfängt, und dem Schalter (2) liegt,
**dadurch gekennzeichnet,**
daß das logische Gatter ein Paar Feldeffekttransistoren (M1, M2) enthält, die mit ihren Gate-Anschlüssen (G1 , G2) zusammengeschaltet sind, um den ersten Eingangsanschluß (B) zu bilden, und mit den Drainanschlüssen (D1, D2) zusammengeschaltet sind, um den Ausgang (O) der Treiberschaltung für den Schalter (2) zu bilden, und daß der Spannungsverdoppler aufweist:
- einen Kondensator (C), der mit einem Anschluß an den zweiten Eingangsanschluß (A) und mit einem zweiten Anschluß an den Source-Anschluß des einen (M2) der Transistoren (M1, M2) angeschlossen ist, um zur Leistungsversorgung des logischen Gatters eine gepumpte Spannung bereitszustellen; und
- eine Diode (D), die den zweiten Anschluß des Kondensators mit einer Konstantspannungsversorgung (Vdd) verbindet.

2. Schaltung nach Anspruch 1,
**dadurch gekennzeichnet,**
daß die Diode (D) von der Spannungsversorgung (Vdd) in Durchlaßrichtung gespannt wird.

3. Schaltung nach Anspruch 1,
**dadurch gekennzeichnet,**
daß das Paar von Transistoren (M1, M2) einen ersten, N-Kanal-MOS-Transistor (M1) und einen zweiten, P-Kanal-MOS-Transistor (M2) aufweist, die mit ihren Drainanschlüssen (D1, D2) zusammengeschaltet sind, um den Treiberausgang (O) der Schaltung zu bilden.

4. Schaltung nach Anspruch 1,
**dadurch gekennzeichnet,**
daß das erste Taktsignal (F-) und das zweite Taktsignal (F) einander nicht überlappen.

## Revendications

1. Un circuit de commande destiné à un commutateur électronique (2), ledit circuit de commande comprenant une porte logique recevant sur une première borne d'entrée (B) un premier signal d'horloge (F-) ayant une fréquence prédéterminée, et un doubleur de tension connecté entre une seconde borne d'entrée (A) recevant un second signal d'horloge (F) et le commutateur (2), caractérisé en ce que ladite porte logique comprend une paire de transistors à effet de champ (M1, M2) ayant des bornes de grille respectives (G1 , G2) en commun pour former ladite première borne d'entrée (B) et des bornes de drain respectives (D1, D2) en commun pour former la sortie (O) du circuit de commande vers ledit commutateur (2), et en ce que ledit doubleur de tension comprend :
- un condensateur (C) ayant une borne connectée à ladite seconde borne d'entrée (A) et une seconde borne connectée à la borne de source de l'un (M2) desdits transistors (M1, M2) pour fournir une tension de pompage servant à alimenter ladite porte logique ; et
- une diode (D) connectant la seconde borne dudit condensateur à une alimentation en tension constante (Vdd).

2. Un circuit selon la revendication 1, caractérisé en ce que ladite diode (D) est polarisée dans le sens direct par rapport à ladite alimentation en tension (Vdd).

3. Un circuit selon la revendication 1, caractérisé en ce que ladite paire de transistors (M1, M2) comprend un premier transistor MOS à canal N (M1) et un second transistor MOS à canal P (M2) ayant des bornes de drain respectives (D1, D2) en commun pour former la sortie de commande (O) dudit circuit.

4. Un circuit selon la revendication 1, caractérisé en ce que ledit premier signal d'horloge (F-) et ledit second signal d'horloge (F) ne se chevauchent pas.
